# EUROPÄISCHE PATENTSCHRIFT

(11) **EP 0 981 435 B1**
(45) Veröffentlichungstag und Bekanntmachung des Hinweises auf die Patenterteilung: **29.08.2001**
(21) Anmeldenummer: 98932020.5
(22) Anmeldetag: 28.04.1998
(51) Int. Cl.: B32B 7/12, G06K 19/04, G06K 19/077

(54) **KLEBEVERBINDUNG**
BONDED JOINT
RACCORD PAR COLLAGE

(30) Priorität: 15.05.1997 DE 29708687 U
(43) Veröffentlichungstag der Anmeldung: 01.03.2000
(73) Patentinhaber: Infineon Technologies AG, 81669 München (DE)
(72) Erfinder: HEINEMANN, Erik, D-93049 Regensburg (DE); HENN, Ralf, D-56579 Hardert (DE); PÜSCHNER, Frank, D-93309 Kelheim (DE)
(74) Vertreter: Fischer, Volker, Dipl.-Ing.
(86) Internationale Anmeldenummer: DE9801176
(87) Internationale Veröffentlichungsnummer: WO9851488

(56) Entgegenhaltungen:
- EP-A- 0 527 438
- WO-A-97/19463
- DE-C- 4 441 931

## Beschreibung

Die Erfindung betrifft eine Klebeverbindung nach dem Oberbegriff des Patentanspruchs 1 bzw. eine Kartenanordnung unter Verwendung einer derartigen Klebeverbindung.

Aus der DE 44 41 931 C1 ist eine Klebverbindung bekannt, bei der ein Halbleitermodul mit einem Chipkartenelement verbunden ist. Das Halbleitermodul besteht aus einem Trageelement, einem sogenannten Leadframe, an dem ein Halbleiterchip befestigt ist. Kontakte auf dem Halbleiterchip sind mittels Bondverbindung an dem Leadframe befestigt. Das Leadframe ist mit einer Klebeverbindung mit dem Kartenelement verbunden. Die Klebeverbindung besteht aus einem mehrschichtigen Klebemittel, das eine flexible Mittelschicht aufweist, die mit den beiden Klebepartnern, die zum einen aus dem Leadframe und zum anderen aus dem Kartenelement bestehen über eine Randschicht verbunden sind. Diese Randschichten bestehen wiederum in vorteilhafter Weise aus einem Heißkleber. Nachteil dieser Anordnung ist, daß die Klebeverbindung zwar flexibel ist, um sich in einer Chipkartenanordnung einer Biegebeanspruchung beispielsweise anzupassen, jedoch nicht die ausreichende Haltbarkeit aufweist.

Der Erfindung liegt daher die Aufgabe zugrunde, eine Klebeverbindung bzw. eine Chipkartenanordnung aus einem Halbleitermodul und einem Kartenelement, die mit einer Klebeverbindung zusammengefügt sind, mit verbesserter Haltbarkeit vorzusehen.

Diese Aufgabe wird erfindungsgemäß dadurch gelöst, daß die Klebeschicht zwischen einer Kernschicht aus Acrylat und den an die Klebepartner angrenzenden Randschichten eine Übergangsschicht aufweist. Auf diese Weise ist eine haltbare und innige Verbindung zwischen dem Schmelzkleber und der Mittelschicht gewährleistet.

Nachfolgend wird die Erfindung anhand eines Ausführungsbeispiels unter Bezugnahme auf die Zeichnung näher erläutert.

### Es zeigen:

- Fig. 1: den grundsätzlichen Aufbau einer erfindungsgemäßen Klebeverbindung und
- Fig. 2: eine Kartenanordnung mit einem Leadframe-Modul.

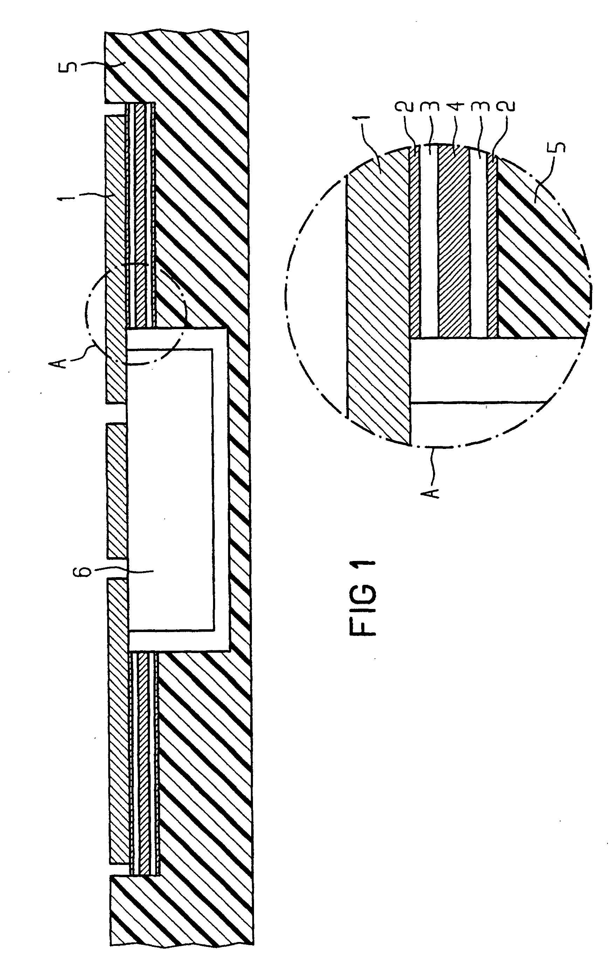

In Fig. 1 ist eine Anordnung dargestellt, bei der im Vergrößerungskreis A eine Klebeverbindung im Einzelnen dargestellt ist. Dabei ist eine Kernschicht 4 vorgesehen, die aus Acrylat besteht. Diese Kernschicht 4 ist beidseitig mit einer Übergangsschicht 3 versehen, wobei für die Übergangsschicht sowohl eine PET(Polyethylenterephthalat)-Folie oder eine Polycarbonat-Folie verwendbar ist. Auf diesen Übergangsschichten 3 sind Randschichten 2 aufgetragen, die wiederum aus einem Schmelzkleber bestehen. Diese Randschichten 2 wiederum bilden die direkte Kontaktschicht zu den Klebepartnern, die miteinander verbunden sind. In der nicht vergrößerten Darstellung von Fig. 1 wird der eine Klebepartner aus einem Kartenelement gebildet, das aus Kunststoff besteht. Der andere Klebepartner stellt ein Trageelement 1 dar, das einen Halbleiterchip 6 trägt. Dieses Trageelement kann grundsätzlich ein metallisches Leadframe oder auch ein Modulträger aus Epoxidharz-glasfaserverstärktem Gewebe oder auch Keramik sein.

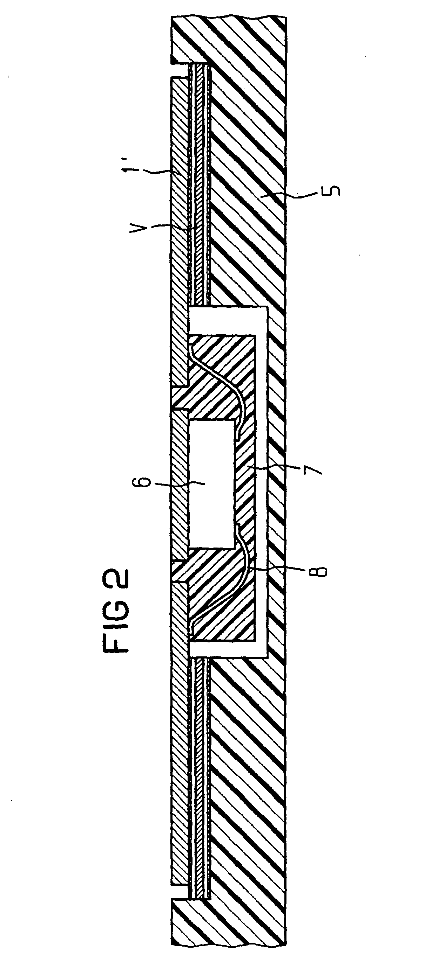

In Fig. 2 ist eine Anordnung dargestellt, bei der die Kartenanordnung wiederum aus einem Kartenelement 5 aus Kunststoff besteht, wobei das Modul aus einem Trageelement l'besteht, das aus einem metallischen leitfähigen Leadframe aufgebaut ist. Wie in Fig. 2 dargestellt ist, sind zwischen dem Halbleiterchip 6 und dem Leadframe 1' Bondverbindungen 8 vorgesehen. Der Halbleiterchip 6 und die Bondverbindungen 8 sind insgesamt von einer Abdeckung 7 abgedeckt. Das Leadframe 1' ist wiederum mittels einer Klebeverbindung V mit dem Kartenelement 5 verbunden, wobei die Klebeverbindung V einen Aufbau aufweist, wie in der Vergrößerung A in Fig. 1 dargestellt ist.

## Patentansprüche

1. Klebeverbindung, die mittels einer Klebeschicht (V) einen Körper (1) aus einem ersten Material mit einem Kunststoffkörper (5) verbindet, wobei die Klebeschicht (V) einen mehrschichtigen Aufbau aufweist, der zusammengesetzt ist aus einer flexiblen Kernschicht (4) und Randschichten (2), die jeweils an den ersten Körper (1) bzw. den Kunststoffkörper (5) angrenzen und aus Heißklebstoff bestehen,
**dadurch gekennzeichnet,**
daß zwischen der Kernschicht und den Randschichten (2) jeweils eine Übergangsschicht (3) angeordnet ist, und daß die kernschicht aus Acrylat besteht.

2. Klebeverbindung nach Anspruch 1,
**dadurch gekennzeichnet,**
daß die Übergangsschicht (3) aus einer PET-Folie besteht.

3. Klebeverbindung nach Anspruch 1,
**dadurch gekennzeichnet,**
daß die Übergangsschicht (3) aus einer Polycarbonat-Folie besteht.

4. Chipkartenanordnung mit einem Trageelement (1; 1') das einen Halbleiter-Chip (6) trägt und einem Kartenelement (5) aus Kunststoff, wobei das Trageelement (1; 1') mittels einer Klebeverbindung nach einem der Ansprüche 1 bis 3 mit dem Kartenelement (5) verbunden ist.

5. Kartenanordnung nach Anspruch 4, wobei das Trageelement (1; 1') elektrisch leitend ist.

6. Kartenanordnung nach Anspruch 4,
**dadurch gekennzeichnet,**
daß das Trageelement (1) aus Epoxidharz-glasfaserverstärktem Gewebe besteht.

7. Kartenanordnung nach Anspruch 4,
**dadurch gekennzeichnet,**
daß das Trageelement (1) aus einem keramischen Material besteht.

## Claims

1. Adhesive joint which connects a body (1) of a first material to a body of plastic (5) by means of an adhesive layer (V), the adhesive layer (V) having a multi-layered structure which is composed of a flexible core layer (4) and outer layers (2) which respectively adjoin the first body (1) and the body of plastic (5) and consist of hot-melt adhesive, **characterized in that** a transitional layer (3) is respectively arranged between the core layer and the outer layers (2), and in that the core layer consists of acrylate.

2. Adhesive joint according to Claim 1,
**characterized in that** the transitional layer (3) comprises a PET film.

3. Adhesive joint according to Claim 1,
**characterized in that** the transitional layer (3) comprises a polycarbonate film.

4. Chip card arrangement with a carrying element (1; 1'), which carries a semiconductor chip (6), and a card element (5) of plastic, the carrying element (1; 1') being connected to the card element (5) by means of an adhesive joint according to one of Claims 1 to 3.

5. Card arrangement according to Claim 4, the carrying element (1; 1') being electrically conductive.

6. Card arrangement according to Claim 4, **characterized in that** the carrying element (1) consists of epoxy-resin glass-fibre-reinforced fabric.

7. Card arrangement according to Claim 4, **characterized in that** the carrying element (1) consists of a ceramic material.

## Revendications

1. Joint collé qui, au moyen d'une couche (V) de colle, relie une pièce (1) en un premier matériau à une pièce (5) en matière plastique, la couche (V) de colle ayant une structure stratifiée et étant composée d'une couche (4) d'âme souple et des couches (2) marginales qui sont respectivement adjacentes à la première pièce (1) et à la pièce (5) en matière plastique et qui sont en colle à chaud, **caractérisé en ce qu**'il est interposé entre la couche d'âme et les couches (2) marginales respectivement une couche (3) de transition et en ce que la couche d'âme est en acrylate.

2. Joint collé suivant la revendication 1, **caractérisé en ce que** la couche (3) de transition est constituée d'une feuille de PET.

3. Joint collé suivant la revendication 1, **caractérisé en ce que** la couche (3) de transition est constituée d'une feuille de polycarbonate.

4. Carte à puce ayant un élément (1 ; 1') support qui porte une puce (6) à semi-conducteur et un élément (5) de carte en matière plastique, l'élément (1 ; 1') support étant relié au moyen d'un joint collé suivant l'une des revendications 1 à 3, à l'élément (5) de carte.

5. Carte suivant la revendication 4, dans laquelle l'élément (1 ; 1') support est conducteur d'électricité.

6. Carte suivant la revendication 4, **caractérisée en ce que** l'élément (1) support est constitué d'un tissu en résine époxyde renforcée par de la fibre de verre.

7. Carte suivant la revendication 4, **caractérisée en ce que** l'élément (1) support est constitué d'un matériau céramique.
